# EUROPEAN PATENT APPLICATION

(11) **EP 4 209 378 A1**
(43) Date of publication of application: **12.07.2023**
(21) Application number: 22150466.5
(22) Date of filing: 06.01.2022
(51) Int. Cl.: B60L 1/00

(54) **ELECTRICAL POWER SUPPLY SYSTEM FOR TRANSPORT REFRIGERATION SYSTEM**

(71) Applicant: Carrier Corporation, Palm Beach Gardens, FL 33418 (US)
(72) Inventor: Wijk, Ruud, 2201 GN Noordwijk (NL); Van der Plaas, Peter, 2201 GN Noordwijk (NL)
(74) Representative: Dehns

(57) **Abstract**

An electrical power supply system 18 for an electric transport refrigeration unit 14 is disclosed. The electrical power supply system 18 is for providing AC power to a refrigeration system and comprises: a DC power source 16 for providing a DC voltage via a low voltage line 22 and a high voltage line 24; an inverter 26 for receiving the DC voltage and converting it to a three phase AC voltage for powering the refrigeration system; and an electromagnetic compatibility, EMC, filter 28 between the inverter 26 and the refrigeration system. The EMC filter 28 uses a common mode current path 30 that connects to a DC link 32, where the DC link is provided between the high voltage line 24 and the low voltage line 22 of the DC power source 16. The common mode current path 30 is hence coupled to the DC link 32 in order to provide a floating current connection for common mode current from the EMC filter 28.

## Description

The present invention relates to an electrical power supply system for an electric transport refrigeration unit as well as to related methods.

Transport refrigeration units are known for temperature and/or humidity controlled transport of goods and include a temperature and/or humidity controlled cargo space for storing and transporting perishable goods. Cold chain distribution systems using transport refrigeration units are used to transport and distribute cargo, or more specifically perishable goods and environmentally sensitive goods (referred to as perishable goods) that may be susceptible to temperature, humidity, and other environmental factors. Perishable goods may include but are not limited to fruits, vegetables, grains, beans, nuts, eggs, dairy, seed, flowers, meat, poultry, fish, ice, and pharmaceuticals. Advantageously, cold chain distribution systems allow perishable goods to be effectively transported and distributed without damage or other undesirable effects.

For such refrigerated transport the required temperature and/or humidity control is provided by a refrigeration system using a refrigeration circuit generally powered by a motor. The motor in prior art transport refrigeration units would often be powered by AC power from a generator that itself is powered by an internal combustion engine. This can be a motive engine of the vehicle or a separate engine of the transport refrigeration unit, which may for example be a trailer unit or an intermodal container. In recent times there has been a development of systems with greater reliance on electrical power, including hybrid systems and also fully electric systems. Fully electric systems generally rely on a DC power source such as a battery. Fully electric refrigerated vehicles require fully electric transport refrigeration units, which in turn requires suitable electrical power supply systems for electric transport refrigeration units.

Viewed from a first aspect, the invention provides an electrical power supply system for an electric transport refrigeration unit, wherein the electrical power supply system is for providing AC power to a refrigeration system, the electrical power supply system comprising: a DC power source for providing a DC voltage via a low voltage line and a high voltage line; an inverter for receiving the DC voltage and converting it to a three phase AC voltage for powering the refrigeration system; and an electromagnetic compatibility, EMC, filter between the inverter and the refrigeration system; wherein the EMC filter uses a common mode current path; wherein a DC link is provided between the high voltage line and the low voltage line of the DC power source; and wherein the common mode current path is coupled to the DC link in order to provide a floating current connection for common mode current from the EMC filter.

With this power supply system it is possible to provide a high quality waveform for the AC power, i.e. a good sine wave, since the use of the DC link for the common mode current path provides an effective ground for the common mode current via the floating current connection. This might in some situations be considered as a floating ground, and it will be understood that it is one that may give better/more consistent performance than the ground of the vehicle chassis. The DC power source may typically be configured to provide a DC voltage in the range 100-1000V, e.g. 200-800V DC. Similar power supply arrangements for industrial applications are arranged with a connection to the electrical ground of the building and/or of the electrical grid, but this is not possible with transport use and they cannot therefore be used for refrigerated transport units. It is known in relation to refrigerated vehicles to use the vehicle chassis "ground" as a common ground connection, and there may be a ground connection from the inverter for connection to such a vehicle chassis ground. However, the inventors have found that connection of the EMC filter common mode current path to this ground not provide good quality AC waveforms for powering the refrigeration system via a DC/AC inverter. This is considered to be in view of fluctuations in the chassis ground voltage as well as interaction with other power supplies of the transport refrigeration unit or related vehicle elements. The chassis ground may also be the ground for a DC circuit at a lower voltage (e.g. 12V or 24V) for power of ancillary equipment and/or for control signals.

The DC link may comprise a coupling between the low voltage line and the high voltage line, such as a coupling comprising at least two capacitors. The connection point where the common mode current path is coupled to the DC link may be in between first and second capacitors of the at least two capacitors, with the first capacitor being between the connection point and the low voltage line and the second capacitor being between the connection point and the high voltage line.

The common mode current path may include a direct conductive connection from the EMC filter to the DC link. There may be no other components in between the EMC filter and the DC link. This may include that there are no other conductive connections, such that there are no branches or other conductive pathways connected to the direct conductive connection from the EMC filter to the DC link. Advantageously, the common mode current path does not connect to the vehicle chassis ground and/or does not connect to earth. For the DC power source there is also advantageously no connection to earth and/or no connection to the vehicle chassis ground, such that the DC power source is effectively floating in relation to ground connections. It can nonetheless provide a reliable and consistent floating current connection for correct operation of the common mode current path.

The EMC filter is provided for the three phase AC output from the inverter and sits in between the inverter and the three phase AC load. The EMC filter may comprise any suitable arrangement of inductors and capacitors, with the common mode current path capacitively connected to all three lines of the three phase AC. One basic configuration uses an inductor on each line with a line branching off between the inductor and the three phase AC load, wherein a capacitor is placed on each of the lines that branch off. These three branched lines may join to form the common mode current path, optionally with a further capacitor on after the joining point.

The DC power source provides a DC voltage on the low and high voltage lines, as discussed above. This provides the DC input to the inverter, with the DC link being connected between the low and high voltage lines prior to the inverter, optionally with no intervening components between the connections to the DC link and the input to the converter. The inverter outputs a three phase AC voltage and in example embodiments it has a generally known form using known components/circuits to perform its DC/AC inverter function. The three phase AC may have a voltage in the range 150 VAC to 800 VAC, such as a voltage of 190 VAC, 230 VAC, 380 VAC or 460 VAC, for example

The electrical power supply system is for an electric transport refrigeration unit (TRU) and in another aspect the invention provides an electric transport refrigeration unit combined with or comprising the electrical power supply system. The transport refrigeration unit is advantageously fully electric, and thus may comprise no separate non-electric power source to supplement the DC power source, such as having no internal combustion engine, e.g. no diesel engine. The DC power source may be provided in combination with the transport refrigeration unit or as a part thereof and may for example comprise one or more batteries. Alternatively the DC power source may be situated elsewhere, with the transport refrigeration unit comprising electrical connections for coupling to the DC power source. The transport refrigeration unit may be provided with energy harvesting means for providing added electrical energy, e.g. for storage via a battery, such as solar, wind or kinetic energy sources. Kinetic energy sources may take the form of energy harvesting means for obtaining energy from driven axles of the transport refrigeration unit and/or during braking of the transport refrigeration unit.

The transport refrigeration unit is for temperature and/or humidity controlled transport of goods and thus in example embodiments the transport refrigeration unit includes a temperature and/or humidity controlled cargo space. The transport refrigeration unit may be a trailer or an intermodal container that is made mobile when coupled with a separate tractor unit. Alternatively the transport refrigeration unit may be integrated into a truck. Advantageously, the electric transport refrigeration unit may need no power from the truck/tractor internal combustion engine, if the vehicle is not itself fully electric. In some implementations both the truck/tractor and the transport refrigeration unit (e.g. a trailer or an intermodal container) may be powered by the same DC power source, e.g. from a commonly used battery power source. In other implementations the transport refrigeration unit has a dedicated, separate, DC power source, e.g. a separate battery power source.

The transport refrigeration unit may comprise the refrigeration system, for example as a refrigeration circuit attached to the cargo space in order to provide temperature and/or humidity control for cargo in the cargo space. This may typically be done by the refrigeration system providing temperature and/or humidity controlled air to the cargo space, such as via passage of air from the cargo space over a heat absorbing heat exchanger of the refrigeration system before the air is returned to the cargo space. The refrigeration system of example embodiments has an AC motor providing the load for the three phase AC power. The AC motor powers the refrigeration system, e.g. as a motor for a compressor (or compressors) of the refrigeration system.

The refrigeration system may comprise a refrigerant compressor, a condenser, one or more condenser fans, an expansion device, an evaporator, and/or one or more associated evaporator fans. Any of these components, if present, may be connected by appropriate refrigerant lines in a closed refrigerant flow circuit. The refrigeration system may be in operative association with a cargo space defined within the transport refrigeration unit (e.g. within a vehicle or trailer) and for maintaining a controlled temperature environment within the cargo space.

In some examples the transport refrigeration unit is provided as a part of a vehicle, which hence includes the temperature and/or humidity controlled cargo space, the refrigeration system and the DC power source. Advantageously the vehicle is fully electric in that it may not comprise any non-electric power source such as an internal combustion engine. The transport refrigeration unit may be or may be comprised as part of a heavy goods vehicle (HGV). For example, the transport refrigeration unit may be provided as a part of a heavy goods vehicle or may be a trailer of a heavy goods vehicle. Alternatively, the transport refrigeration system may be or may be comprised as part of a light goods vehicle (LGV).

In another aspect, the invention provides a method comprising use of the electrical power supply system of the first aspect for powering an electric transport refrigeration unit, wherein the electrical power supply system provides three phase AC power to a refrigeration system, e.g. by powering an AC motor of the refrigeration system. The use of the electrical power supply system may include using any of the other features discussed above, e.g. use of the DC power source for fully electric operation of the transport refrigeration unit without any added power from non-electric sources such as an internal combustion engine of a vehicle.

A yet further aspect provides a method of manufacture of a transport refrigeration unit including providing an electrical power supply system as described in the first aspect. The method may include providing other features for the electrical power supply system as discussed above. Such a method may be used for adaptation of existing transport refrigeration units for electric operation, e.g. by retrofit of a DC power source along with the electrical power supply system. This method may comprise removal of a diesel engine or other non-electric power source from the transport refrigeration unit and replacement of this with the DC power source and the electrical power supply system.

Certain embodiments of the invention will now be described by way of example only and with reference to the accompanying drawings, in which:
Figure 1 shows an example of a transport refrigeration unit in the form of a refrigerated trailer, which is coupled to a tractor/truck; and
Figure 2 is a diagram of a power supply system for a transport refrigeration unit.

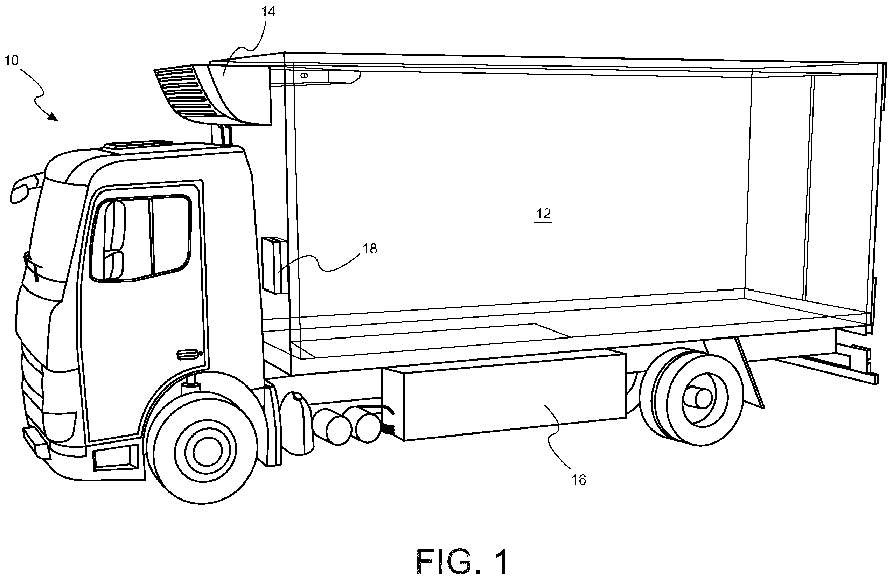

As shown in Figure 1, a refrigerated vehicle 10, which by way of example is a truck 10, can include a temperature and/or humidity controlled cargo space 12 as well as a transport refrigeration unit (TRU) 14. Advantageously the TRU 14 is fully electrically powered in that it does not rely on any non-electric power source such as an internal combustion engine. Instead, it is powered from a DC power source 16, which in this case comprises batteries 16 carried by the vehicle 10.

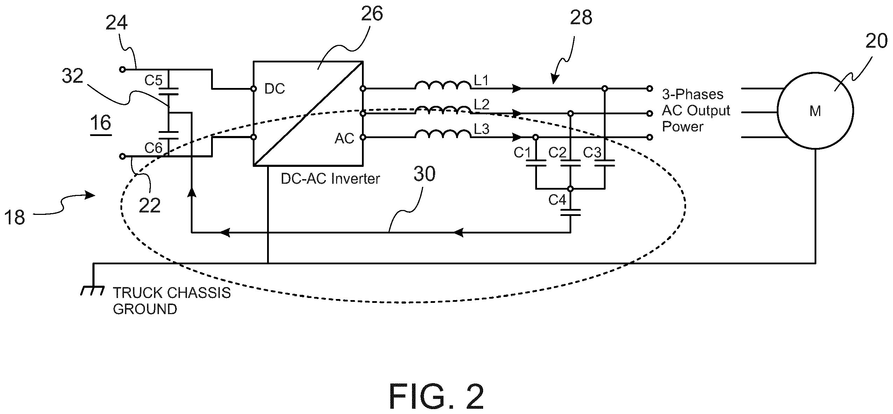

In order to effectively power the TRU 14 an electrical power supply system 18 is used. The electrical power supply system 18 is for providing AC power to a refrigeration system of the TRU 14, which includes a motor 20 as shown in Figure 2. The motor is an AC motor 20 that requires three phase AC power. The AC motor 20 can powers the refrigeration system, e.g. as a motor 20 for a compressor (or compressors) of the refrigeration system.

Figure 2 shows further detail of the electrical power supply system 18. The DC power source 16, e.g. batteries 16, provides a DC voltage via a low voltage line 22 and a high voltage line 24. This is coupled to an inverter 26 for receiving the DC voltage and converting it to a three phase AC voltage for powering the motor 20, which is hence a load for the three phase AC power. An electromagnetic compatibility, EMC, filter 28 is placed between the inverter 26 and the motor 20. The EMC filter 28 uses a common mode current path 30, which requires a suitbale current connection. In order to avoid use of the truck chassis ground the common mode current path 30 is coupled to a DC link 32 that is provided between the high voltage line 24 and the low voltage line 22 of the DC power source 16. Thus, as discussed above, the DC link 32 is used to provide a floating current connection for the common mode current from the EMC filter 28.

The DC power source can be configured to provide a DC voltage in the range 100-1000V, e.g. 200-800V DC. The DC link 32 is a coupling between the low voltage line 22 and the high voltage line 24, which in this example comprises two capacitors. The connection point for the common mode current path 30 is in between first and second capacitors of the DC link 32.

Advantageously, the common mode current path does not connect to the vehicle chassis ground, which has been found to interfere with the quality of the AC power supply to the motor 20 but it does not need to connect to earth since the DC link 32 provides a suitable ground for the common mode current. For the DC power source there is also no connection to earth and/or no connection to the vehicle chassis ground, such that the DC power source is effectively floating in relation to ground connections.

The electrical power supply system 18 is thus used for powering the electric TRU 14 by powering the AC motor 20 of the refrigeration system.

Conveniently, the advantages of the power supply system 18 described herein do not need any modification to the TRU 14. Thus, it is straightforward to adapt existing designs to be electrically powered via a DC power source. This can include adaptation of existing transport refrigeration units in order to provide for electric operation, e.g. by removal of a diesel engine and retrofit of a DC power source 16 along with the electrical power supply system 18, without the need to change the motor 20 or otherwise modify the TRU 14.

In some implementations of the above, the power supply system 18 is integrated into the TRU 14, either as an added part not present before, or to replace other power supply systems present in an existing TRU design.

## Claims

1. An electrical power supply system for an electric transport refrigeration unit, wherein the electrical power supply system is for providing AC power to a refrigeration system, the electrical power supply system comprising:
a DC power source for providing a DC voltage via a low voltage line and a high voltage line;
an inverter for receiving the DC voltage and converting it to a three phase AC voltage for powering the refrigeration system; and
an electromagnetic compatibility, EMC, filter between the inverter and the refrigeration system;
wherein the EMC filter uses a common mode current path;
wherein a DC link is provided between the high voltage line and the low voltage line of the DC power source; and
wherein the common mode current path is coupled to the DC link in order to provide a floating current connection for common mode current from the EMC filter.

2. An electrical power supply system as claimed in claim 1, wherein DC link comprises a coupling between the low voltage line and the high voltage line, the coupling including at least a first capacity and a second capacitor, wherein a connection point where the common mode current path is coupled to the DC link is in between the first capacitor and the second capacitor.

3. An electrical power supply system as claimed in claim 1 or 2, wherein the common mode current path includes a direct conductive connection from the EMC filter to the DC link, with no other components in between the EMC filter and the DC link.

4. An electrical power supply system as claimed in claim 1, 2 or 3, wherein the common mode current path does not connect to the vehicle chassis ground and does not connect to earth.

5. An electrical power supply system as claimed in any preceding claim, wherein the DC power source has no connection to earth and no connection to the vehicle chassis ground.

6. An electric transport refrigeration unit combined with or comprising the electrical power supply system as claimed in any preceding claim.

7. A transport refrigeration unit as claimed in claim 6, being for temperature and/or humidity controlled transport of goods and including a temperature and/or humidity controlled cargo space.

8. A refrigerated vehicle comprising the transport refrigeration unit with cargo space as claimed in claim 7.

9. A refrigerated vehicle as claimed in claim 8, wherein the vehicle is fully electric and does not comprise an internal combustion engine.

10. A method of providing refrigerated transport, the method comprising use of the electrical power supply system of any of claims 1 to 5 for powering an electric transport refrigeration unit, wherein the electrical power supply system provides three phase AC power to a refrigeration system of the transport refrigeration unit.

11. A method of manufacture of a transport refrigeration unit including providing an electrical power supply system as described in any of claims 1 to 5.

12. A method as claimed in claim 10 or 11, including adaptation of an existing transport refrigeration unit for electric operation by retrofit of a DC power source along with the electrical power supply system.

## Amended claims

### Amended claims in accordance with Rule 137(2) EPC.

1. An electrical power supply system (18) for an electric transport refrigeration unit (14), wherein the electrical power supply system (18) is for providing AC power to a refrigeration system, the electrical power supply system (18) comprising:
a DC power source (16) for providing a DC voltage via a low voltage line (22) and a high voltage line (24);
an inverter (26) for receiving the DC voltage and converting it to a three phase AC voltage for powering the refrigeration system; and
an electromagnetic compatibility, EMC, filter (28) between the inverter (26) and the refrigeration system;
wherein the EMC filter (28) uses a common mode current path (30);
wherein a DC link (32) is provided between the high voltage line (24) and the low voltage line (22) of the DC power source (16), the DC link (32) comprising a coupling between the low voltage line (22) and the high voltage line (24), the coupling including at least a first capacitor and a second capacitor, wherein a connection point where the common mode current path (30) is coupled to the DC link (32) is in between the first capacitor and the second capacitor;
wherein the common mode current path (30) is coupled to the DC link (32) in order to provide a floating current connection for common mode current from the EMC filter (28), the common mode current path (30) includes a direct conductive connection from the EMC filter (28) to the DC link (32), with no other components in between the EMC filter (28) and the DC link (32); and
wherein the common mode current path (30) does not connect to the vehicle (10) chassis ground and does not connect to earth.

2. An electrical power supply system (18) as claimed in claim 1, wherein the DC power source (16) has no connection to earth and no connection to the vehicle (10) chassis ground.

3. An electric transport refrigeration unit (14) combined with or comprising the electrical power supply system (18) as claimed in claim 1 or 2.

4. A transport refrigeration unit (14) as claimed in claim 3, being for temperature and/or humidity controlled transport of goods and including a temperature and/or humidity controlled cargo space.

5. A refrigerated vehicle (10) comprising the transport refrigeration unit (14) with cargo space as claimed in claim 4.

6. A refrigerated vehicle (10) as claimed in claim 5, wherein the vehicle (10) is fully electric and does not comprise an internal combustion engine.

7. A method of providing refrigerated transport, the method comprising use of the electrical power supply system (18) of claim 1 or 2 for powering an electric transport refrigeration unit (14), wherein the electrical power supply system (18) provides three phase AC power to a refrigeration system of the transport refrigeration unit (14).

8. A method of manufacture of a transport refrigeration unit (14) including providing an electrical power supply system (18) as described in claim 1 or 2.

9. A method as claimed in claim 7 or 8, including adaptation of an existing transport refrigeration unit (14) for electric operation by retrofit of a DC power source (16) along with the electrical power supply system (18).
